# EUROPEAN PATENT SPECIFICATION

(11) **EP 0 666 602 B1**
(45) Date of publication and mention of the grant of the patent: **24.06.1998**
(21) Application number: 95200805.0
(22) Date of filing: 10.04.1991
(51) Int. Cl.: H01L 31/18, H01L 31/0304

(54) **Method of manufacturing a GaAs solar cell on a Si substrate**
Herstellungsverfahren einer GaAs Solarzelle auf einem Si-Substrat
Procédé de fabrication d'une cellule solaire en GaAs sur un substrat Si

(30) Priority: 13.04.1990 JP 98802/90
(43) Date of publication of application: 09.08.1995
(62) Divisional of application: 92201965.8
(73) Proprietor: MITSUBISHI DENKI KABUSHIKI KAISHA, Tokyo (JP); NIPPON TELEGRAPH AND TELEPHONE CORPORATION, Tokyo (JP)
(72) Inventor: Oohara, Takahiko, Higashimurayama-shi, Tokyo (JP); Ohmachi, Yoshiro, Higashiyamato-shi, Tokyo (JP); Kadota, Yoshiaki, Ebina-shi, Kanagawa-ken (JP); Mitsui, Kotaro, c/o Mitsubishi Denki K. K., Mizuhara 4-chome, Itami-shi, Hyogo-ken (JP); Ogasawara, Nobuyoshi, c/o Mitsubishi Denki K. K., Mizuhara 4-chome, Itami-shi, Hyogo-ken (JP); Nishimura, Takashi, c/o Mitsubishi Denki K. K., Mizuhara 4-chome, Itami-shi, Hyogo-ken (JP)
(74) Representative: Beresford, Keith Denis Lewis

(56) References cited:
- EP-A- 0 317 124
- EP-A- 0 328 405
- PATENT ABSTRACTS OF JAPAN vol. 013 no. 139 (E-738) ,6 April 1989 & JP-A-63 302576

## Description

The present invention relates to a method of manufacturing a GaAs solar cell on an Si substrate.

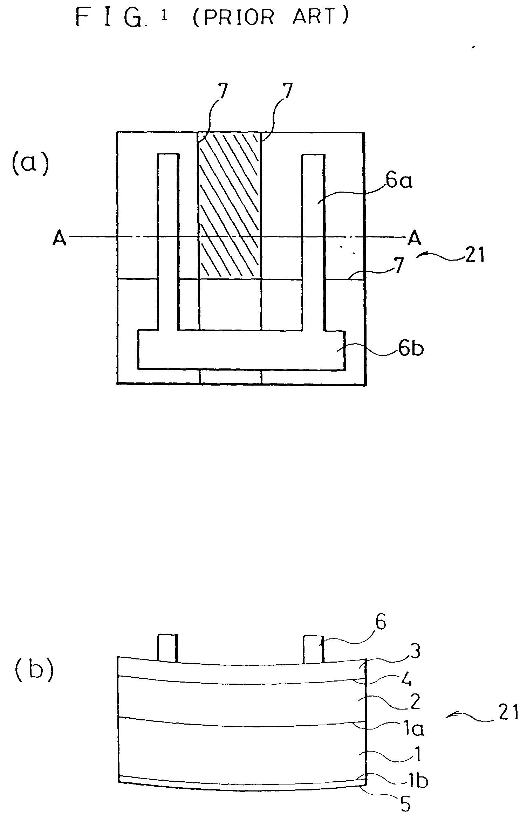

Figures 1(a) and 1(b) are views showing a structure of a conventional GaAs solar cell on an Si substrate, in which figure 1(a) is a plan view and figure 1(b) is a sectional view taken along a line A-A of figure 1(a). In figures 1(a) and 1(b), reference numeral 1 designates an Si substrate. An n type GaAs layer 2 and a p type GaAs layer 3 which serve as active layers are laminated on a first main surface la of the Si substrate 1 and then an anode electrode (p type electrode) 6 is formed on the p type GaAs layer 3 and a cathode electrode (n type electrode) 5 is provided on a second main surface 1b of the Si substrate 1. Thus, a solar cell 21 is formed.

The GaAs solar cell 21 on the Si substrate is normally manufactured by the following method.

First, the n type GaAs layer 2 and the p type GaAs layer 3 are sequentially formed on the first main surface la of the n type Si substrate 1 having a surface orientation of approximately (100) by a method of crystal growth of a compound semiconductor, such as MOCVD method. Thus, a pn junction 4 which generates a photovoltaic effect is formed.
Then, as an electrode for taking a photoelectromotive force out, the anode electrode (p side electrode) 6 is selectively formed on the p type GaAs and the cathode electrode (n side electrode) 5 is formed on the whole surface of the second main surface 1b of the Si substrate 1. The anode electrode 6 comprises collecting electrodes 6a for collecting a photoelectric current and a common electrode 6b for connecting the collecting electrodes to an outside circuit. In addition, these electrodes are formed by sputtering or a vapour deposition method and Ti/Ag is normally used as their materials.

However, the conventional GaAs solar cell on the Si substrate has the following problems. That is, since the n type GaAs layer 2 and the p type GaAs layer 3 are usually formed at a high temperature of 700 to 800°C, when a wafer on which the above GaAs layers are formed is taken out at a room temperature, a large warpage is generated because of a difference in thermal expansion coefficient between GaAs and Si as shown in figure 1(b) As the thickness of the GaAs layer is increased, the degree of this warpage becomes large. When the thickness of the GaAs layer exceeds 3µm, a crack is generated. On the other hand, as the thickness of the GaAs layer is increased, a dislocation density in the GaAs layer is reduced. Therefore, in order to assure sufficient performance of the solar cell, the thickness should be 4 to 5 µm. Thus, a crack is generated in the operation layer (active layer) of the conventional solar cell. Particularly, a region surrounded by the crack 7 on which the collecting electrode 6a is not provided, which region is shown by slanting lines in figure 1(a), is a loss region because the generated photoelectric current cannot be collected.

In addition, even if a crack is not generated at this stage, since a considerably large thermal stress remains in the GaAs layer, when slight stress is applied from the outside, a crack is generated easily in the GaAs layer. Since the warpage is concave when the GaAs layer is on the upper side as shown in figure 1(b), a crack is generated easily when a stress is applied from the direction of the second main surface 1b of the Si substrate, that is, when a tensile stress is applied to the GaAs layer. Therefore, when the wafer is flattened in photolithography processing for patterning the p type electrode 6 or when interconnector welding for modulation is performed on the first electrode 5 side during assembly, a crack is usually generated.

A partial solution to the above problem is provided by EP-A-0 328 405. As disclosed therein, epitaxial grown GaAs p-doped and n-doped layers are divided into spaced islands by a photolithography and etch process applied after epitaxial growth. In the structure thus formed further generation of cracks is inhibited by the small size of each island.

In an alternative method disclosed by EP-A-0328405 the upper surface of a substrate is coated by a suitable protective material. The protective layer is then covered by a layer of photoresist. By employing conventional photolithographic masking and etching techniques the protective layer is selectively removed to expose the upper surface of the substrate in a pattern of individual areas separated from one another by an intervening network of protective material. Semiconductor material is then grown on the exposed surface of the substrate. The masking material is then removed.

This alternative method avoids problems of both the generation of cracks during manufacture and during use as any cracks formed will be confined by the small size of each island.

The present invention is intended to solve the above problems and it is thus an object of the present invention to provide a method of manufacturing a GaAs solar cell on an Si substrate in which crack generation is prevented, or at least much reduced without the use of a masking layer of a protective material.

A method of manufacturing a solar cell in accordance with the present invention is defined by the claims appended.

A solar cell produced by the method of the present invention comprises a plurality of island-shaped buffer layers formed in one element region which are formed by dividing a GaAs buffer layer formed on the first main surface of the first conductivity type Si substrate, to which a first conductivity type impurity of high concentration is applied, by checkered mesa grooves and active layers formed of first and second GaAs layers of first and second conductivity types which are sequentially formed on each island-shaped buffer layer, in which the second conductivity type GaAs layer in each island is connected to at least one second conductivity type collecting electrode connected to common electrode. As a result, mechanical force applied to the GaAs crystal is reduced because the size of the island-shaped active layer is small, so that crack generation is inhibited.

Other objects and advantages of the present invention will become apparent from the detailed description given hereinafter; it should be understood, however, that the detailed description and specific embodiment are given by way of illustration only.

In the accompanying drawings:
Figures 1(a) and 1(b) show in plan view and cross-section, respectively, a conventional GaAs solar cell on a Si substrate; and
Figures 2(a) and 2(b) show in plan view and cross-section a GaAs solar cell on a Si substrate, as a preferred example of the present invention.

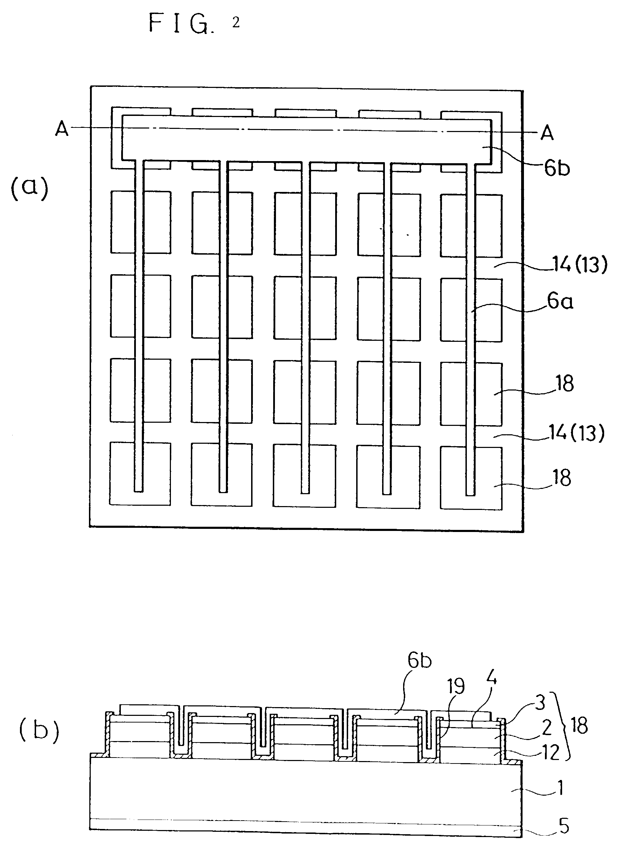

A preferred embodiment of the present invention will be described now. Figures 2(a) and 2(b) are views showing a solar cell manufactured in accordance with the method of the present invention, in which figure 2(a) is a plan view and figure 2(b) is a sectional view taken along a line A-A of figure 2(a). The solar cell is formed as follows.

A n⁺ GaAs buffer layer 12 is formed first on a Si substrate (1) and then checkered mesa grooves 13 are provided so that a plurality of islands 18 of the n⁺ GaAs buffer layer may be formed. Then, an n type GaAs layer 2 and a p type GaAs layer 3 are grown by organo-metallic chemical vapour deposition (MOCVD), or by molecular beam epitaxy (MBE), for example. They are grown selectively only at each island part in which the n⁺ GaAs layer remains. Then, the GaAs layer surplus in the vicinity of each island 18 is removed and then a mesa groove (14) which is a little larger than the mesa groove 13 is produced. Then, pn junctions exposed at the sides of each island are protected with an insulating film 19. Finally, an n type electrode 5 is formed on the second main surface of the n type Si substrate and a p type electrode 6 comprising collecting electrodes 6a and a common electrode 6b is formed on the p type GaAs layer surface. In this case, at least one collecting electrode 6a or the common electrode 6b is produced on each island 18. As described above, since a plurality of islands of a GaAs layer are provided and used in one element, the size of each individual GaAs layer island is small and residual stress in the vicinity of the GaAs layer is reduced, so that crack generation is inhibited. Even if a crack is generated, it spreads only in one island, and its influence is thus minimised.

## Claims

1. A method of manufacturing a solar cell having an active layer comprising GaAs on a Si substrate including steps of:
producing a GaAs buffer layer (12) 3µm or less in thickness, containing a high concentration of a first conductivity type impurity on the surface of a first conductivity type Si substrate (1);
dividing said GaAs buffer layer (12) into spaced islands (18) by providing mesa grooves in a checkered pattern (13);
selectively growing on each island (18) a first layer (2) of GaAs containing a first conductivity type impurity, then a second layer (3) of GaAs containing a second conductivity type impurity, opposite in conductivity type to that of said first conductivity type; and
removing surplus GaAs in the vicinity of each island (18).

2. A method as claimed in claim 1 wherein, after removal of surplus GaAs, the sides of pn junctions formed between said first and second layers (2,3) of GaAs are protected by providing an insulating film (19) thereon.

3. A method as claimed in claim 2 wherein, following provision of said insulating film (19), collecting electrodes (6a) and a connective common electrode (6b) are formed, connecting together the second layer (3) of GaAs of each island (18).

## Patentansprüche

1. Verfahren zur Herstellung einer Solarzelle, welche eine aus GaAs bestehende aktive Schicht auf einem Si-Substrat aufweist, mit den Schritten:
Herstellen einer GaAs-Pufferschicht (12) mit einer Dicke von 3µm oder weniger, welche eine hohe Konzentration von Störstellen eines ersten Leitfähigkeitstyps aufweist, auf der Oberfläche eines Si-Substrats (1) des ersten Leitfähigkeitstyps;
Teilen der GaAs-Pufferschicht (12) in voneinander beabständete Inseln (18) durch Vorsehen von mesaförmigen Rinnen in einer schachbrettartigen Struktur (13);
Selektives Aufwachsen einer ersten Schicht (2) aus GaAs, welche Störstellen des ersten Leitfähigkeitstyps aufweist, und danach einer zweiten Schicht (3) aus GaAs, welche Störstellen eines zweiten Leitfähigkeitstyps entgegengesetzt zu dem ersten Leitfähigkeitstyp aufweist, auf jeder Insel (18); und
Entfernen von überschüssigem GaAs in der Nähe jeder Insel (18).

2. Verfahren nach Anspruch 1, dadurch gekennzeichnet, daß nach dem Entfernen von überschüssigem GaAs die Seiten von zwischen den ersten und zweiten Schichten (2, 3) aus GaAs gebildeten pn-Übergängen durch Bereitstellen einer Isolierschicht (19) darauf geschützt werden.

3. Verfahren nach Anspruch 2, dadurch gekennzeichnet, daß folgend auf das Bereitstellen der Isolierschicht (19) Auffangelektroden (6a) und eine gemeinsame Verbindungselektrode (6b) gebildet werden, welche die zweite Schicht (3) aus GaAs jeder Insel (18) miteinander verbinden.

## Revendications

1. Méthode de fabrication d'une pile solaire ayant une couche active comprenant GaAs sur un substrat en Si, comprenant les étapes de :
produire une couche tampon (12) en GaAs de 3 µm ou moins d'épaisseur, contenant une forte concentration en impureté d'un premier type de conductivité à la surface d'un substrat en Si (1) du premier type de conductivité ;
diviser ladite couche tampon (12) en GaAs en îlots espacés (18) en formant des gorges mésa en un motif en échiquier (13) ;
faire sélectivement croître sur chaque îlot (18) une première couche 2 de GaAs contenant une impureté d'un premier type de conductivité puis une seconde couche (3) en GaAs contenant une impureté d'un second type de conductivité, opposé en type de conductivité à celui du premier type de conductivité ; et
retirer GaAs en surplus à proximité de chaque îlot (18).

2. Méthode selon la revendication 1 où après avoir retiré GaAs en surplus, les côtés des jonctions pn formées entre lesdites première et seconde couches (2, 3) en GaAs sont protégés en prévoyant un film isolant (19) par dessus.

3. Méthode selon la revendication 2 où, après avoir formé ledit film isolant (19), des électrodes collectrices (6a) et une électrode commune de connexion (6b) sont formées, connectant ensemble la seconde couche 3 en GaAs de chaque îlot (18).
